# DEMANDE DE BREVET EUROPEEN

(11) **EP 4 766 131 A1**
(43) Date de publication de la demande: **24.06.2026**
(21) Numéro de dépôt: 25223731.8
(22) Date de dépôt: 16.12.2025
(51) Int. Cl.: H10P 95/00, H10P 90/00, H10H 20/01

(54) **PROCEDE DE REALISATION D'UN DISPOSITIF ELECTRONIQUE**

(30) Priorité: 17.12.2024 FR 2414281
(71) Demandeur: Commissariat à l'Energie Atomique et aux Energies Alternatives, 75015 Paris (FR)
(72) Inventeur: PERNEL, Carole, 38054 GRENOBLE CEDEX 09 (FR); GWOZIECKI, Romain, 38054 GRENOBLE CEDEX 09 (FR); TORRENGO, Simona, 38054 GRENOBLE CEDEX 09 (FR)
(74) Mandataire: Cabinet Beaumont

(57) **Abrégé**

La présente description concerne un procédé de réalisation d'un dispositif électronique, le procédé comprenant les étapes successives suivantes :
a) former, sur un substrat de support (101), un empilement d'électropolissage (109) comprenant :
- une première couche (117) semiconductrice sacrificielle ;
- une deuxième couche (113) semiconductrice de transport de charges ; et
- une troisième couche (115) semiconductrice de protection de la deuxième couche (113), la troisième couche (115) étant interposée entre les première (117) et deuxième (113) couches et présentant un niveau de dopage strictement inférieur à ceux des première (117) et deuxième (113) couches ;

b) former, du côté d'une face de l'empilement d'électropolissage (109) opposée au substrat de support (101), au moins une quatrième couche (121, 123, 125) à base de nitrure de gallium ; et
c) retirer le substrat de support (101) par électropolissage de la première couche (117).

## Description

### Domaine technique

La présente description concerne de façon générale les dispositifs électroniques, et en particulier les dispositifs électroniques de puissance et leurs procédés de réalisation.

### Technique antérieure

Des dispositifs électroniques de puissance, par exemple des dispositifs comprenant au moins un transistor à haute mobilité électronique, ou transistor HEMT (de l'anglais « High-Electron-Mobility Transistor »), et des procédés de réalisation de tels dispositifs ont été proposés. Les transistors HEMT sont généralement réalisés à partir d'un empilement de couches à base de nitrure de gallium (GaN), car ce matériau présente un champ de claquage, ou champ critique, élevé et une mobilité électronique importante. Cela permet de réaliser des transistors présentant des dimensions réduites et une forte tenue en tension.

Pour réduire le coût de fabrication des transistors HEMT, l'empilement de couches à base de GaN est généralement formé par croissance épitaxiale sur un substrat de support en un autre matériau semiconducteur, par exemple une plaquette en silicium d'un diamètre d'au moins 150 mm, voire d'au moins 200 mm. Des couches tampon (« buffer », en anglais) sont alors interposées entre le substrat de support et l'empilement de couches à base de GaN. Les couches tampon permettent non seulement de réaliser une adaptation de paramètre de maille et de coefficient d'expansion thermique entre le substrat de support et l'empilement de couches à base de GaN, pour obtenir des couches à base de GaN de qualité cristalline élevée, mais aussi d'isoler électriquement l'empilement de couches à base de GaN du substrat de support, pour supporter une tension de blocage du transistor HEMT en fonctionnement. Le fait que les couches tampon réalisent à la fois des fonctions d'adaptation de paramètre de maille et d'isolation électrique rend leur optimisation particulièrement difficile.

### Résumé de l'invention

Il existe un besoin d'améliorer les dispositifs électroniques de puissance existants et leurs procédés de réalisation. Il existe notamment un besoin de découpler les fonctions d'adaptation de paramètre de maille et de coefficient d'expansion thermique des fonctions d'isolation électrique.

Pour cela, un mode de réalisation prévoit un procédé de réalisation d'un dispositif électronique, le procédé comprenant les étapes successives suivantes :
a) former, sur un substrat de support, un empilement d'électropolissage comprenant :
   - une première couche semiconductrice sacrificielle ;
   - une deuxième couche semiconductrice de transport de charges ; et
   - une troisième couche semiconductrice de protection de la deuxième couche, la troisième couche étant interposée entre les première et deuxième couches et présentant un niveau de dopage strictement inférieur à ceux des première et deuxième couches ;
b) former, du côté d'une face de l'empilement d'électropolissage opposée au substrat de support, au moins une quatrième couche à base de nitrure de gallium ; et
c) retirer le substrat de support par électropolissage de la première couche en appliquant, entre une électrode en contact avec la deuxième ou la troisième couche et une contre-électrode disposée dans une solution électrolytique, un courant de polarisation traversant, dans cet ordre, les deuxième, troisième et première couches.

Selon un mode de réalisation, le procédé comprend en outre, postérieurement à l'étape c), une étape d) de report de ladite au moins une quatrième couche sur un substrat de report.

Selon un mode de réalisation, ladite au moins une quatrième couche fait partie d'un empilement actif de composant électronique de puissance.

Selon un mode de réalisation, le procédé comprend en outre, entre les étapes b) et c), une étape de formation, dans et sur l'empilement actif, d'au moins un transistor HEMT.

Selon un mode de réalisation, la première couche est située sur et en contact avec une face de la troisième couche opposée au substrat de support.

Selon un mode de réalisation, le procédé comprend en outre, postérieurement à l'étape de formation dudit au moins un transistor HEMT et préalablement à l'étape c), une étape de formation d'un ou plusieurs vias ou d'une ou plusieurs tranchées s'étendant depuis une face de l'empilement actif opposée au substrat de support, à travers l'empilement actif et à travers les deuxième et troisième couches, jusque dans l'épaisseur de la première couche.

Selon un mode de réalisation, la deuxième couche est située sur et en contact avec une face de la troisième couche opposée au substrat de support.

Selon un mode de réalisation, le procédé comprend en outre, postérieurement à l'étape de formation dudit au moins un transistor HEMT et préalablement à l'étape c), une étape de formation d'un ou plusieurs vias s'étendant depuis une face du substrat de support opposée à l'empilement d'électropolissage, à travers le substrat de support, jusque dans l'épaisseur de la première couche.

Selon un mode de réalisation, ladite au moins une quatrième couche est une unique couche en nitrure de gallium.

Selon un mode de réalisation, le procédé comprend en outre, postérieurement à l'étape d), des étapes de formation d'un empilement actif de composant électronique de puissance et de formation, dans et sur l'empilement actif, d'au moins un transistor HEMT.

Selon un mode de réalisation, la première couche présente un niveau de dopage au moins dix fois supérieur à celui de la troisième couche.

Selon un mode de réalisation :
- les première et deuxième couches présentent chacune un niveau de dopage égal à environ 1.10¹⁹ at.cm⁻³ ; et
- la troisième couche présente un niveau de dopage égal à environ 1.10¹⁶ at.cm⁻³.

Selon un mode de réalisation, le procédé comprend en outre, entre les étapes b) et c), une étape de fixation d'une poignée du côté d'une face de l'empilement d'électropolissage opposée au substrat de support.

Selon un mode de réalisation, l'empilement d'électropolissage comprend en outre une cinquième couche semiconductrice de transition interposée entre le substrat de support et la première couche.

Selon un mode de réalisation, le procédé comprend en outre, préalablement à l'étape a), une étape de formation, sur le substrat de support, d'un empilement tampon comprenant au moins une couche d'adaptation de paramètre de maille et de coefficient d'expansion thermique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue de côté et en coupe, schématique et partielle, d'une structure obtenue à l'issue d'une étape d'un procédé de fabrication d'un dispositif électronique selon un mode de réalisation ;
la figure 2A, la figure 2B, la figure 2C et la figure 2D sont des vues de côté et en coupe, schématiques et partielles, de structures obtenues à l'issue d'étapes successives d'un procédé de réalisation d'un dispositif électronique selon un mode de réalisation ;
la figure 3A et la figure 3B sont des vues de côté et en coupe, schématiques et partielles, de structures obtenues à l'issue d'étapes successives d'un procédé de réalisation d'un dispositif électronique selon un mode de réalisation ;
la figure 4 est un abaque représentant des zones de pré-rupture, de porosification et d'électropolissage d'une couche en nitrure de gallium en fonction d'un niveau de dopage et d'une tension de polarisation appliquée à ladite couche ;
la figure 5A, la figure 5B, la figure 5C et la figure 5D sont des vues de côté et en coupe, schématiques et partielles, de structures obtenues à l'issue d'étapes successives d'un procédé de réalisation d'un dispositif électronique selon un mode de réalisation ; et
la figure 6A, la figure 6B et la figure 6C sont des vues de côté et en coupe, schématiques et partielles, de structures obtenues à l'issue d'étapes successives d'un procédé de réalisation d'un dispositif électronique selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les différentes applications des dispositifs électroniques de puissance de la présente description, notamment les divers appareils susceptibles d'intégrer de tels dispositifs, n'ont pas été détaillées, les modes de réalisation décrits étant compatibles avec tous ou la plupart des applications et des appareils usuels mettant en œuvre au moins un dispositif électronique de puissance, moyennant éventuellement des adaptations à la portée de la personne du métier à la lecture de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % ou à 10° près, de préférence à 5 % ou à 5° près.

Sauf précision contraire, les termes « isolant » et « conducteur » signifient respectivement électriquement isolant et électriquement conducteur.

Sauf précision contraire, l'expression « en contact avec » signifie « en contact mécanique avec ».

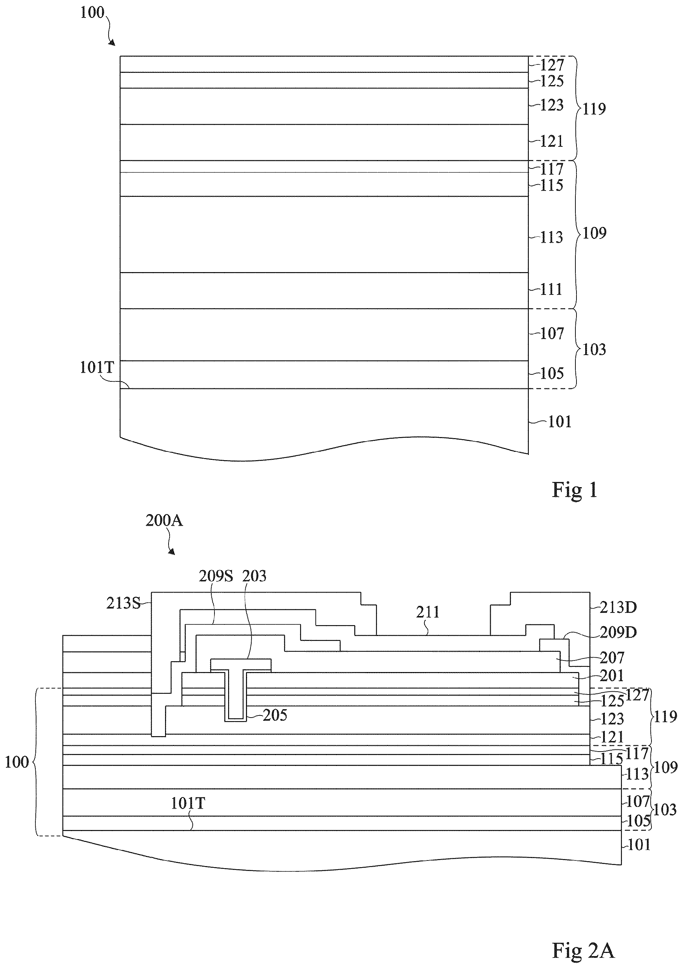

La figure 1 est une vue de côté et en coupe, schématique et partielle, d'une structure 100 obtenue à l'issue d'une étape d'un procédé de fabrication d'un dispositif électronique selon un mode de réalisation.

Dans l'exemple représenté, la structure 100 comprend un substrat de support 101. Le substrat de support 101 est par exemple une plaquette ou un morceau de plaquette en un matériau semiconducteur, par exemple le silicium. À titre de variante, le substrat de support 101 est en saphir, en carbure de silicium (SiC), en nitrure de gallium (GaN), etc. Le matériau du substrat de support 101 en par exemple choisi en fonction de la présence, ou non, d'une étape ultérieure de perçage ou de découpe de ce substrat. Le substrat de support 101 présente par exemple un diamètre supérieur ou égal à 150 mm, par exemple égal à environ 150 mm ou à environ 200 mm.

Dans l'exemple illustré, la structure 100 comprend en outre un empilement 103 de couches tampon revêtant une face supérieure 101T du substrat de support 101. Dans l'exemple représenté, l'empilement 103 comprend une couche tampon 105 située sur et en contact avec la face supérieure 101T du substrat de support 101 et une autre couche tampon 107 située sur et en contact avec la face supérieure de la couche tampon 105.

À titre d'exemple, la couche tampon 105 est en nitrure d'aluminium (AlN). La couche tampon 105 présente par exemple une épaisseur de l'ordre de plusieurs centaines de nanomètres, par exemple égale à environ 250 nm. La couche tampon 105 peut présenter une structure monocouche ou multicouche.

À titre d'exemple, la couche tampon 107 est en nitrure d'aluminium-gallium (AlGaN). La couche tampon 107 présente par exemple une épaisseur de l'ordre de plusieurs centaines de nanomètres, par exemple égale à environ 600 nm. La couche tampon 107 présente par exemple une structure monocouche présentant un gradient de concentration molaire en aluminium, par exemple une concentration molaire en aluminium plus élevée au voisinage de sa face inférieure qu'au voisinage de sa face supérieure. À titre de variante, la couche tampon 107 présente une structure multicouche constituée d'un ensemble de couches dont la concentration en aluminium est d'autant plus faible que la couche est éloignée de la couche tampon 105.

La figure 1 illustre un exemple dans lequel l'empilement 103 comprend deux couches tampon. Toutefois, cet exemple n'est pas limitatif et l'empilement 103 peut, à titre de variante, comprendre un nombre quelconque de couches tampon analogues aux couches 105 et 107.

Selon un mode de réalisation, la structure 100 comprend en outre un empilement d'électropolissage 109 situé sur le substrat de support 101. Dans l'exemple représenté, l'empilement d'électropolissage 109 revêt l'empilement 103 de couches tampon.

Dans l'exemple illustré en figure 1, l'empilement d'électropolissage 109 comprend :
- une couche 111 de transition située sur et en contact avec la face supérieure de la couche tampon 107 ;
- une couche 113 de transport de charges située sur et en contact avec la face supérieure de la couche 111 ;
- une couche 115 de protection de la couche 113 située sur et en contact avec la face supérieure de la couche 113 ; et
- une couche 117 sacrificielle située sur et en contact avec la face supérieure de la couche 115.

Chaque couche 111, 113, 115, 117 est par exemple à base d'un matériau semiconducteur, par exemple le GaN.

La couche 111 présente par exemple une structure multicouche comprenant une couche en GaN dopé au carbone (GaN:C) revêtant la couche tampon 107 et une autre couche en GaN non intentionnellement dopé (GaN UID, de l'anglais « unintentionally doped » ou GaN NID, de l'anglais « Non-Intentionally Doped ») revêtant la couche en GaN:C. À titre d'exemple, la couche en GaN:C présente un niveau de dopage de l'ordre de 10¹⁸ at.cm⁻³. La couche en GaN:C présente par exemple une épaisseur égale à plusieurs centaines de nanomètres, par exemple égale à environ 600 nm. À titre d'exemple, la couche en GaN UID présente un niveau de dopage de l'ordre de 1.10¹⁶ at.cm⁻³. La couche en GaN UID présente par exemple une épaisseur inférieure à celle de la couche en GaN:C, par exemple égale à environ 300 nm. À titre de variante, la couche 111 est par exemple une unique couche, par exemple en GaN:C, présentant par exemple une épaisseur comprise dans une plage allant de 100 à 600 nm, ou en GaN UID, présentant par exemple une épaisseur comprise dans une plage allant de 100 à 300 nm. Le choix de la structure de la couche 111 dépend par exemple de la nature des couches tampon de l'empilement 103 et du type de substrat de support 101 choisi.

À titre de variante, la couche 111 est omise.

La couche 113 est par exemple en GaN fortement dopé de type N (N-GaN). À titre d'exemple, la couche 113 présente un niveau de dopage égal à environ 1.10¹⁹ at. cm⁻³. La couche 113 présente par exemple une épaisseur comprise dans une plage allant de 500 nm à 1,5 µm. À titre d'exemple, la couche 113 présente une épaisseur égale à environ 1 µm.

La couche 115 est par exemple en GaN UID. À titre d'exemple, la couche 115 présente un niveau de dopage analogue ou sensiblement égal à celui de la région en GaN UID de la couche 111. La couche 115 présente par exemple une épaisseur comprise dans une plage allant de 200 à 500 nm.

La couche 117 est par exemple en GaN fortement dopé de type N. À titre d'exemple, la couche 117 présente un niveau de dopage supérieur ou égal à celui de la couche 113. Le niveau de dopage de la couche 117 est en particulier très supérieur, par exemple au moins dix fois supérieur, à celui de la couche 115. La couche 117 présente par exemple un niveau de dopage égal à environ 1.10¹⁹ at.cm⁻³. La couche 117 présente une épaisseur strictement inférieure à celle de la couche 113, par exemple de l'ordre de quelques dizaines ou quelques centaines de nanomètres. À titre d'exemple, l'épaisseur de la couche 117 est comprise dans une plage allant de 20 à 500 nm.

Dans l'exemple représenté, la structure 100 comprend en outre un empilement actif 119 de composant électronique de puissance, par exemple un empilement actif de transistor à haute mobilité électronique « High-Electron-Mobility Transistor » - HEMT, en anglais) à base de GaN, situé sur l'empilement d'électropolissage 109. Dans cet exemple, l'empilement 109 est interposé entre l'empilement 103 de couches tampon et l'empilement 119.

Dans l'exemple illustré en figure 1, l'empilement actif 119 de composant électronique de puissance comprend :
- une couche 121 en GaN dopé de type P (P-GaN) située sur et en contact avec la face supérieure de la couche sacrificielle 117 ;
- une couche 123 en GaN UID située sur et en contact avec la face supérieure de la couche 121 ;
- une couche 125 en AlGaN située sur et en contact avec la face supérieure de la couche 123 ; et
- une couche 127 en nitrure de silicium (SiN), en AlN ou en GaN située sur et en contact avec la face supérieure de la couche 125.

Dans cet exemple, la couche 121 présente un type de dopage (le type P) opposé à celui des couches 117 et 113 (le type N). La couche 121 est par exemple dopée au magnésium (Mg) et présente par exemple un niveau de dopage compris dans une plage allant de 1.10¹⁷ à 5.10¹⁸ at.cm⁻³. La couche 121 présente par exemple une épaisseur comprise dans une plage allant de 50 nm à 200 nm. À titre d'exemple, la couche 121 présente une épaisseur égale à environ 100 nm.

À titre de variante, la couche 121 peut être en GaN non intentionnellement dopé (GaN UID), en AlGaN dopé de type P (P-AlGaN) ou en AlGaN non intentionnellement dopé (AlGaN UID).

La couche 123 est par exemple destinée à former une région de canal du transistor HEMT. La couche 123 présente par exemple un niveau de dopage analogue à celui de la couche 111, par exemple inférieur ou égal à 1.10¹⁶ at.cm⁻³. À titre d'exemple, la couche 123 présente une épaisseur égale à environ 300 nm.

La couche 125 présente par exemple une concentration molaire en aluminium comprise dans une plage allant de 12 à 30 %, ou supérieure à 60 %. À titre d'exemple, la couche 125 présente une épaisseur comprise dans une plage allant de 10 à 30 nm.

La couche 127 est par exemple une couche de protection de la couche 125. À titre d'exemple, la couche 127 présente une épaisseur comprise dans une plage allant de 2 à 10 nm.

Dans la structure 100, l'empilement 103 de couches tampon permet d'accommoder des différences de paramètres de maille et de coefficients d'expansion thermique entre le substrat de support 101 et les couches de l'empilement actif 119. Les couches tampon 105 et 107 de l'empilement 103 permettent notamment d'assurer la qualité cristalline des couches à base de GaN de l'empilement actif 119.

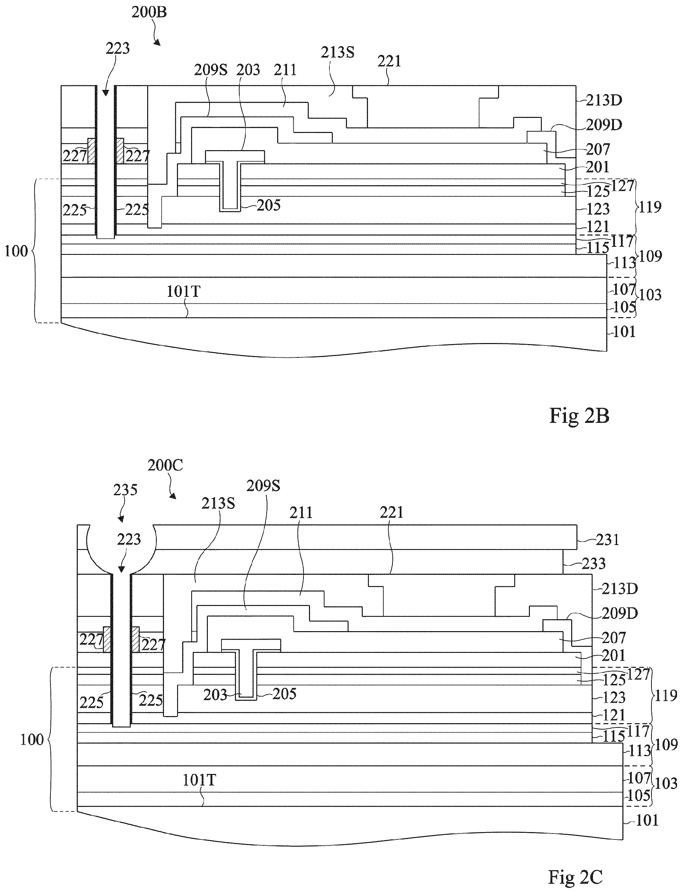

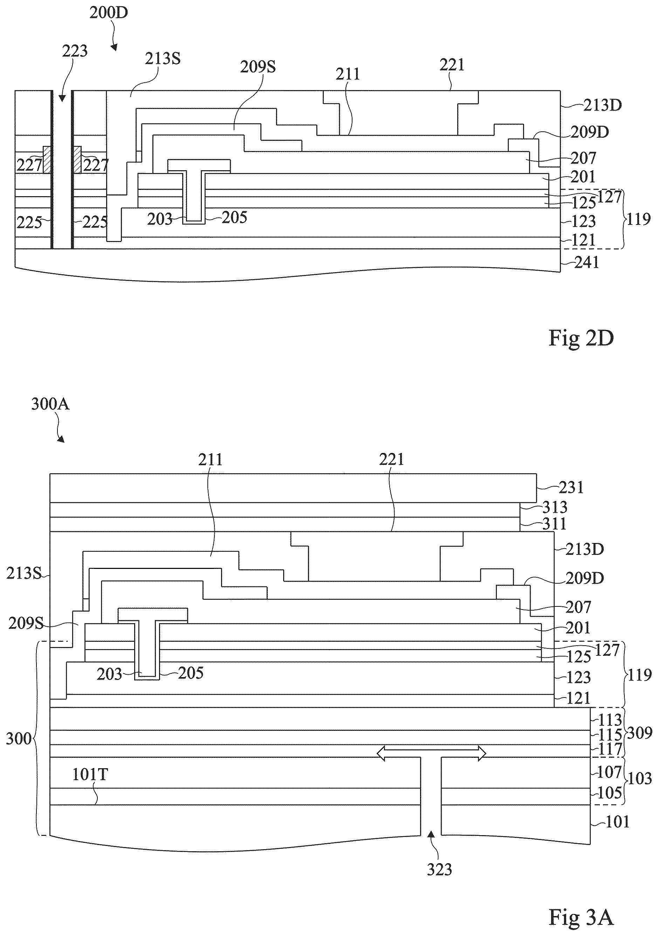

La figure 2A, la figure 2B, la figure 2C et la figure 2D sont des vues de côté et en coupe, schématiques et partielles, de structures obtenues à l'issue d'étapes successives d'un procédé de réalisation d'un dispositif électronique selon un mode de réalisation.

La figure 2A illustre plus précisément une structure 200A obtenue à l'issue d'une étape de réalisation de la structure 100 précédemment décrite en relation avec la figure 1. Dans la structure 200A, l'empilement d'électropolissage 109 est dépourvu de la couche 111 de transition.

Dans l'exemple représenté, une couche de passivation 201 revêt l'empilement actif 119 de composant électronique de puissance de la structure 100. Dans cet exemple, la couche de passivation 201 est plus précisément située sur et en contact avec la face supérieure de la couche 127. À titre d'exemple, la couche de passivation 201 est en SiN, en SiO₂ ou en Al₂O₃.

Dans l'exemple illustré, la structure 200A comprend en outre une région conductrice 203 en forme de T comportant une partie horizontale s'étendant latéralement sur et en contact avec la face supérieure de la couche de passivation 201 et une partie verticale s'étendant verticalement, depuis la face supérieure de la couche 201, dans l'empilement formé par les couches 201, 127 et 125 et pénétrant dans l'épaisseur de la couche 123. La région conductrice 203 est par exemple en un métal ou en un alliage métallique, par exemple un alliage à base de nitrure de titane (TiN) et de tungstène (W).

Dans l'exemple représenté, les flancs et le fond de la région conductrice 203 sont revêtus d'une couche isolante 205 permettant d'isoler la région conductrice 203 vis-à-vis des couches 123, 125, 127 et 201. À titre d'exemple, la couche isolante est en un oxyde, par exemple l'oxyde de silicium ou l'oxyde d'aluminium, ou en un nitrure, par exemple le nitrure d'aluminium.

La région conductrice 203 et la couche isolante 205 forment par exemple une région de commande, ou région de grille, d'un transistor HEMT formé dans et sur l'empilement actif 119.

Dans l'exemple illustré, la structure 200A comprend en outre une couche isolante 207 revêtant la couche de passivation 201 ainsi que la face supérieure et les flancs de la partie horizontale du T formé par la région conductrice 203. À titre d'exemple, la couche isolante 207 est en orthosilicate de tétraéthyle (TEOS).

Dans l'exemple représenté, la structure 200A comprend en outre des régions conductrices 209S et 209D disjointes. La région 209S est située au-dessus de la région conductrice 203 et la région 209D est située à distance de la région 203. Dans l'exemple illustré, la région conductrice 209S s'étend latéralement sur et en contact avec la face supérieure de la couche isolante 207, à l'aplomb de la partie horizontale du T formé par la région conductrice 203 sous-jacente. La région conductrice 209S traverse chaque couche 207, 201, 127, 125, 123 et pénètre dans l'épaisseur de la couche 121. Dans l'exemple représenté, la région 209D s'étend latéralement sur et en contact avec la face supérieure de la couche 207 et traverse chaque couche 207, 201, 127, 125.

Les régions conductrices 209S et 209D sont par exemple en un métal ou en un alliage métallique. À titre d'exemple, les régions conductrices 209S et 209D sont en le même matériau que la région conductrice 203.

Lorsque le transistor HEMT est en fonctionnement, les régions conductrices 209S et 209D forment par exemple des contacts de source et de drain du transistor HEMT. Bien que cela n'ait pas été illustré en figure 2A, le transistor HEMT comprend par exemple en outre un contact de grille connecté à la région conductrice 203.

Dans l'exemple illustré, la structure 200A comprend en outre une couche isolante 211 revêtant la couche isolante 207. La couche isolante 211 est plus précisément située sur et en contact avec des parties de la face supérieure de la couche isolante 207 non revêtues des régions conductrices 209S et 209D. En outre, la couche isolante 211 est située sur et en contact avec au moins une partie des faces supérieures et des flancs des régions conductrices 209S et 209D. À titre d'exemple, la couche isolante 211 est en TEOS.

Dans l'exemple représenté, la structure 200A comprend en outre des régions conductrices 213S et 213D. Les régions 213S et 213D sont respectivement connectées aux régions 209S et 209D. Dans l'exemple illustré, les régions 213S et 213D sont respectivement situées sur et en contact avec les régions 209S et 209D et sur et en contact avec des parties de la couche isolante 211.

Les régions conductrices 213S et 213D forment par exemple respectivement des électrodes de source et de drain du transistor HEMT. Bien que cela n'ait pas été illustré en figure 2A, le transistor HEMT comprend par exemple en outre une électrode de grille connectée à la région conductrice 203.

Dans le transistor HEMT, un gaz d'électrons bidimensionnel (2DEG) se forme dans la couche 123 à proximité de l'interface entre les couches 123 et 125. Les régions conductrices 209S et 209D sont en contact avec le gaz d'électrons bidimensionnel. Dans l'exemple représenté, le transistor HEMT est normalement bloqué car le gaz d'électrons bidimensionnel est interrompu par la région de grille comprenant la région conductrice 203 revêtue de la couche isolante 205. Dans cet exemple, le gaz d'électrons bidimensionnel est discontinu et comprend deux parties situées de part et d'autre de la région de grille du transistor HEMT.

Lorsqu'une tension V_{gs} inférieure à une tension Vₜₕ de seuil du transistor, par exemple une tension V_{gs} sensiblement nulle, est appliquée entre l'électrode de grille (non représentée) et l'électrode de source 213S, la région de grille encastrée dans la couche 123 empêche les électrons de circuler entre l'électrode de source 213S et l'électrode de drain 213D. Le transistor est alors dans un état bloqué.

En revanche, lorsque la tension V_{gs} appliquée entre l'électrode de grille et l'électrode de source 213S excède la tension Vₜₕ de seuil du transistor, des électrons peuvent circuler entre l'électrode de source 213S et l'électrode de drain 213D. Le transistor est alors dans un état passant. À l'état passant, les électrons circulent d'une partie à l'autre du gaz d'électrons bidimensionnel en contournant la région de grille. Plus précisément, lorsque le transistor est passant et soumis à une tension de polarisation appliquée entre son drain et sa source, les électrons empruntent alors, pour circuler d'un côté à l'autre de la grille, un chemin de conduction située à l'intérieur de la couche 123 le long de l'interface entre la couche 123 et la couche isolante 205.

La figure 2B illustre une structure 200B obtenue, à partir de la structure 200A, à l'issue d'étapes ultérieures de dépôt d'une couche isolante 221 et de formation d'un ou plusieurs vias 223. Afin de ne pas surcharger le dessin, un seul via 223 a été représenté en figure 2B étant entendu que la structure 200B peut comprendre un nombre quelconque de vias 223. À titre de variante, le via 223 peut être remplacé par une tranchée correspondant à un chemin de découpe du transistor HEMT.

Dans l'exemple représenté, la couche isolante 221 revêt la couche isolante 211 ainsi que des faces latérales des régions conductrices 213S et 213D. Dans l'exemple illustré, la couche isolante 221 affleure les faces supérieures des régions conductrices 213S et 213D et comble tous les espaces libres s'étendant latéralement entre les régions 213S et 213D. À titre d'exemple, la couche isolante 221 est en le même matériau que la couche isolante 211.

Dans l'exemple illustré, le via 223 s'étend verticalement depuis la face supérieure de la couche 221, à travers les couches 221, 211, 207, 201, 127, 125, 123 et 121, jusque dans l'épaisseur de la couche sacrificielle 117. Le via 223 présente un ratio entre sa dimension latérale (par exemple son diamètre, dans le cas d'un via de section circulaire) et sa profondeur favorable à la gravure. À titre d'exemple, une épaisseur cumulée d'environ 10 à 20 µm de matériau isolant du type SiN ou SiO₂ est gravée, puis moins de 1 µm d'épaisseur de matériau semiconducteur III-V, par exemple de l'AlGaN, du GaN ou de l'AlN, est gravée. Les parois du via 223 sont revêtues d'une couche isolante 225, à l'exception de parties des parois du via 223 situées dans la couche 117. À titre de variante, les parties des parois du via 223 situées dans la couche 117 sont revêtues de la couche isolante 225. Le fond du via 223 n'est pas revêtu de la couche isolante 225 et est constitué par une partie de la couche 117. À titre d'exemple, le via 223 présente une dimension latérale maximale de l'ordre de 100 µm.

Le via 223 est par exemple réalisé par gravure à un emplacement d'un futur chemin de découpe du dispositif, ouverture depuis la face supérieure de la couche isolante 221 jusqu'à la face supérieure de la couche sacrificielle 117, dépôt de la couche isolante 225 sur les flancs et le fond de l'ouverture, retrait de la couche isolante 225 au fond de l'ouverture et gravure débouchant dans la couche sacrificielle 117.

Dans l'exemple représenté, la structure 200B comprend en outre des espaceurs 227 formés dans la couche 207 de part et d'autre du via 223. À titre d'exemple, les espaceurs 227 sont en un nitrure ou en un oxyde, par exemple un nitrure ou un oxyde de silicium. Les espaceurs 227 sont par exemple formés par PECVD (de l'anglais « Plasma-Enhanced Chemical Vapor Deposition » - dépôt chimique en phase vapeur assisté par plasma).

La figure 2C illustre une structure 200C obtenue, à partir de la structure 200B, à l'issue d'une étape ultérieure de fixation d'une poignée 231 du côté de la face supérieure de la structure 200B. Dans l'exemple représenté, la poignée 231 est collée au moyen d'une couche de colle 233. Une ouverture 235 est en outre réalisée dans la poignée 231 et dans la couche de colle 233 à l'aplomb du via 223. À titre d'exemple, la poignée 231 est une plaquette ou un morceau de plaquette en silicium, en verre, etc. La poignée 231 présente par exemple des dimensions latérales sensiblement identiques à celles du substrat de support 101.

La figure 2D illustre une structure 200D obtenue, à partir de la structure 200C, à l'issue d'une étape ultérieure de retrait du substrat de support 101 par électropolissage de la couche sacrificielle 117. Pour cela, la structure 200C est par exemple plongée dans un bain contenant une solution électrolytique et un potentiel est par exemple appliqué entre une électrode en contact avec la couche 113 et une contre-électrode plongée dans la solution électrolytique. L'électrode en contact avec la couche 113 est par exemple située sur et en contact avec une partie de la face supérieure de la couche 113 non revêtue de la couche 115 (du côté droit de la structure 200C). À titre de variante, l'électrode est en contact avec la couche 115, l'électrode étant par exemple alors située sur et en contact avec une partie de la face supérieure de la couche 115 non revêtue de la couche 117. Par ailleurs, la contre-électrode est par exemple située au-dessus de la structure 200C, par exemple en vis-à-vis de la poignée 231. La solution électrolytique dans laquelle est plongée la structure 200C pénètre dans l'ouverture 235 et dans le via 223. Cela permet de mettre la solution électrolytique en contact avec la couche 117.

Lors de l'application du potentiel, un courant de polarisation circulant depuis l'électrode en contact avec la couche 113 ou 115 vers la contre-électrode traverse, dans cet ordre, la couche 113, la couche 115 et la couche 117. Le courant de polarisation provoque un retrait de la couche sacrificielle 117 par électropolissage. Cela conduit à dissocier l'empilement actif 119 de l'empilement tampon 103 revêtant le substrat de support 101.

Au cours de cette étape, la couche isolante 225 permet d'éviter que la solution électrolytique ne vienne en contact avec les couches de l'empilement actif 119 et avec les couches isolantes 201, 207, 211 et 221.

Une fois le substrat de support 101 retiré, la face arrière est libérée pour permettre par exemple un dépôt d'une couche en un matériau diélectrique présentant par exemple une épaisseur comprise dans une plage allant de 1 à 2 µm suivi d'un dépôt d'une couche métallique. À titre d'exemple, le substrat de report 241 présente des dimensions latérales sensiblement égales, aux dispersions de fabrication près, à celles du substrat de support 101.

La poignée 231 et la couche de colle 233 sont par exemple ensuite retirées.

Un avantage du procédé décrit ci-dessus en relation avec les figures 2A à 2D est qu'il permet de découpler d'une part les fonctions d'adaptation de paramètre de maille et de coefficient d'expansion thermique, assurées dans ce cas par les couches 105 et 107 de l'empilement tampon 103, et d'autre part la fonction d'isolation électrique, assurée par le substrat de report 241. Cela permet d'améliorer la qualité cristalline des couches de l'empilement actif 119 et/ou d'augmenter la tenue en tension du transistor HEMT à l'état bloqué.

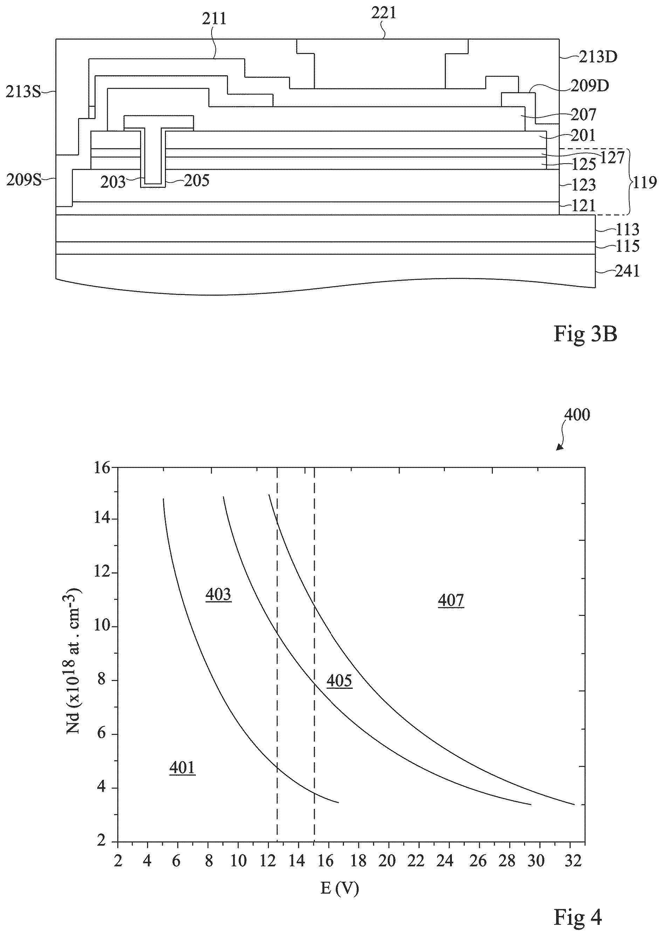

La figure 3A et la figure 3B sont des vues de côté et en coupe, schématiques et partielles, de structures obtenues à l'issue d'étapes successives d'un procédé de réalisation d'un dispositif électronique selon un mode de réalisation.

La figure 3A illustre plus précisément une structure 300A comprenant des éléments en commun avec la structure 200A précédemment décrite en relation avec la figure 2A. Ces éléments communs ne seront pas détaillés à nouveau ci-après. La structure 300A diffère de la structure 200A en ce que la structure 300A comprend, à la place de la structure 100, une structure 300 analogue à la structure 100 mais dans laquelle l'ordre des couches 113, 115 et 117 a été interverti. Dans la structure 300, les couches 113, 115 et 117 font partie d'un empilement d'électropolissage 309.

Dans l'empilement d'électropolissage 309 :
- la couche sacrificielle 117 est située sur et en contact avec la face supérieure de la couche tampon 107 ;
- la couche 115 de protection est située sur et en contact avec la face supérieure de la couche 117 ; et
- la couche 113 de transport de charges est située sur et en contact avec la face supérieure de la couche 115.

Bien que cela n'ait pas été représenté en figure 3A, l'empilement d'électropolissage 309 de la structure 300A peut, à titre de variante, comprendre en outre la couche 111 de transition. Dans ce cas, la couche 111 est interposée entre la couche tampon 107 et la couche sacrificielle 117.

Dans l'exemple représenté, la structure 300A comprend la couche isolante 221. En outre, la structure 300A comprend des couches isolantes 311 et 313 revêtant la couche isolante 221 et les faces supérieures des régions conductrices 213S et 213D. Les couches isolantes 311 et 313 sont par exemple en un oxyde, par exemple l'oxyde de silicium. Dans l'exemple illustré, les couches isolantes 311 et 313 sont interposées entre la couche isolante 221 et la poignée 231.

À titre d'exemple, la couche isolante 311 est déposée du côté de la face supérieure de la structure. Par ailleurs, la couche isolante 313 est déposée sur une face de la poignée 231. L'ensemble comprenant la poignée 231 et la couche isolante 313 est alors par exemple mis en contact, par la face de la couche isolante 313 opposée à la poignée 231, avec la couche isolante 311. Au cours de cette étape, la poignée 231 est fixée à la structure précédemment décrite. À titre d'exemple, la fixation est obtenue par collage direct, par exemple par collage moléculaire, entre les deux surfaces mises en contact.

Par ailleurs, au cours de cette étape, un ou plusieurs vias 323 sont formés depuis la face inférieure du substrat de support 101. Afin de ne pas surcharger le dessin, un seul via 323 a été représenté en figure 3A. À titre de variante, le ou les vias 323 peuvent être remplacés par des tranchées.

Dans l'exemple illustré, le via 323 s'étend verticalement depuis la face inférieure du substrat de support 101, à travers le substrat de support 101 et les couches 105 et 107 de l'empilement tampon 103, jusque dans l'épaisseur de la couche sacrificielle 117.

Le via 323 est par exemple réalisé par gravure débouchant dans l'épaisseur de la couche sacrificielle 117.

La figure 3B illustre une structure 300B obtenue, à partir de la structure 300A, à l'issue d'une étape ultérieure de retrait du substrat de support 101 par électropolissage de la couche sacrificielle 117, par exemple de manière analogue à ce qui a été décrit précédemment en relation avec la figure 2D.

Une fois le substrat de support 101 retiré, la structure est par exemple reportée sur le substrat de report 241. La poignée 231 et les couches isolantes 311 et 313 sont par exemple ensuite retirées.

Dans l'exemple représenté, les couches 113 et 115 n'ont pas été retirées. Toutefois, cet exemple n'est pas limitatif et un retrait des couches 113 et 115 peut, à titre de variante, être prévu avant report sur le substrat 241. Les couches 113 et 115 sont par exemple retirées en appliquant, entre l'électrode en contact avec la couche 113 et la contre-électrode, un potentiel supérieur à celui utilisé pour réaliser l'électropolissage de la couche sacrificielle 117.

Le procédé décrit ci-dessus en relation avec les figures 3A et 3B présente des avantages similaires à ceux du procédé précédemment décrit en relation avec les figures 2A à 2D. Un autre avantage du procédé des figures 3A et 3B est que la réalisation du ou des vias 323 ne requiert pas d'alignement par rapport à des chemins de découpe du dispositif. En outre, les vias 323 ne traversent pas l'empilement actif 119, réduisant ainsi les risques d'endommagement de cet empilement lors de la réalisation du dispositif.

La figure 4 est un abaque 400 représentant des régions de pré-rupture, de porosification et d'électropolissage d'une couche en GaN, par exemple la couche sacrificielle 117, en fonction d'un niveau de dopage Nd (exprimé en atomes par centimètre cube, at.cm⁻³, les valeurs indiquées en ordonnée étant à multiplier par 10¹⁸) et d'une tension de polarisation E (en volts, V) appliquée à ladite couche.

Dans l'exemple représenté, le graphique comprend :
- une région 401 de pré-rupture (« pre-breakdown », en anglais) dans laquelle la structure cristalline de la couche commence à se dégrader ;
- une région 403 de porosification, dans laquelle des pores se forment à l'intérieur de la couche sans toutefois que ces pores ne diminuent sensiblement la cohésion mécanique de la couche ;
- une région 405 de limite d'électropolissage, dans laquelle un début de dégradation de la cohésion mécanique de la couche est observé ; et
- une région 407 d'électropolissage, dans laquelle la couche est retirée, ou éliminée, sous l'effet de l'application de la tension de polarisation E.

Dans le cas où la couche sacrificielle 117 est en GaN, un niveau de dopage Nd supérieur ou égal à environ 1,4.10¹⁹ at.cm⁻³ et une tension E appliquée à la couche 117 égale à environ 15 V permettent par exemple de mettre en œuvre les étapes d'électropolissage de la couche sacrificielle 117 précédemment décrites en relation avec les figures 2D et 3B. Dans ce cas, la couche 115 de protection présente par exemple un niveau de dopage inférieur ou égal à environ 4.10¹⁸ at.cm⁻³, ce qui permet à la couche 115 de rester dans la région 401 de pré-rupture.

L'épaisseur de la couche sacrificielle 117 est choisie la plus faible possible, de sorte que de sorte l'électropolissage, donc le retrait, de cette couche soit le plus rapide possible, tout en étant suffisamment épaisse pour permettre la gravure des vias 223 ou 323, ou des tranchées, de sorte que ces vias ou ces tranchées débouchent dans la couche 117.

L'épaisseur de la couche 115 de protection est choisie de sorte que la couche 115 soit suffisamment mince pour permettre un bon transfert de charges depuis la couche 113 de transport de charges, et suffisamment épaisse pour demeurer intègre lors de l'étape d'électropolissage de la couche sacrificielle 117.

L'épaisseur de la couche 113 de transport de charges est choisie de sorte que la couche 113 soit suffisamment mince pour ne pas dégrader la qualité cristalline des couches de l'empilement actif 119, et suffisamment épaisse pour demeurer intègre lors de l'étape d'électropolissage de la couche sacrificielle 117, pour éviter des effets de bord dans le cas où le substrat de support 101 présente un diamètre supérieur ou égal à 200 mm, et pour permettre une bonne conduction des charges.

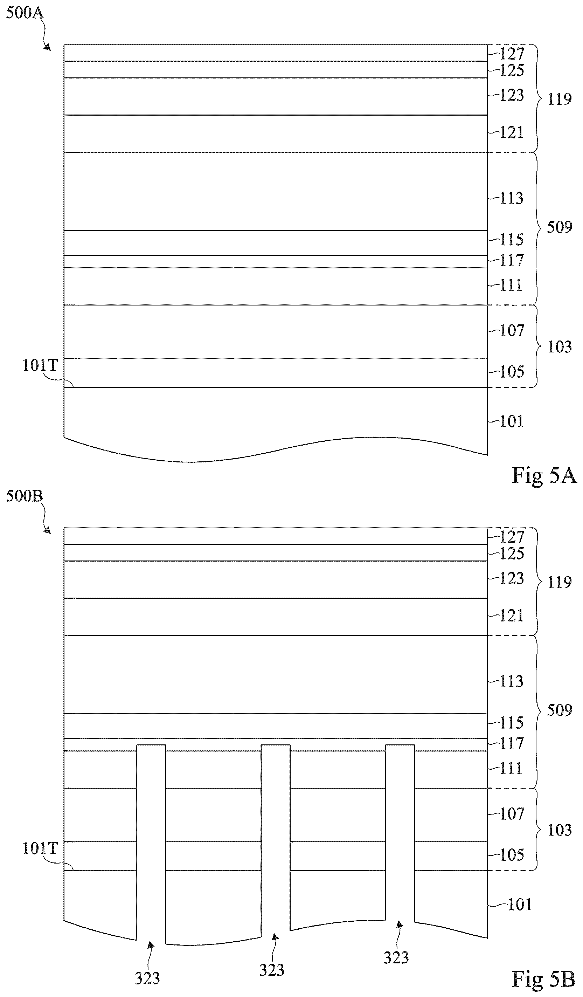

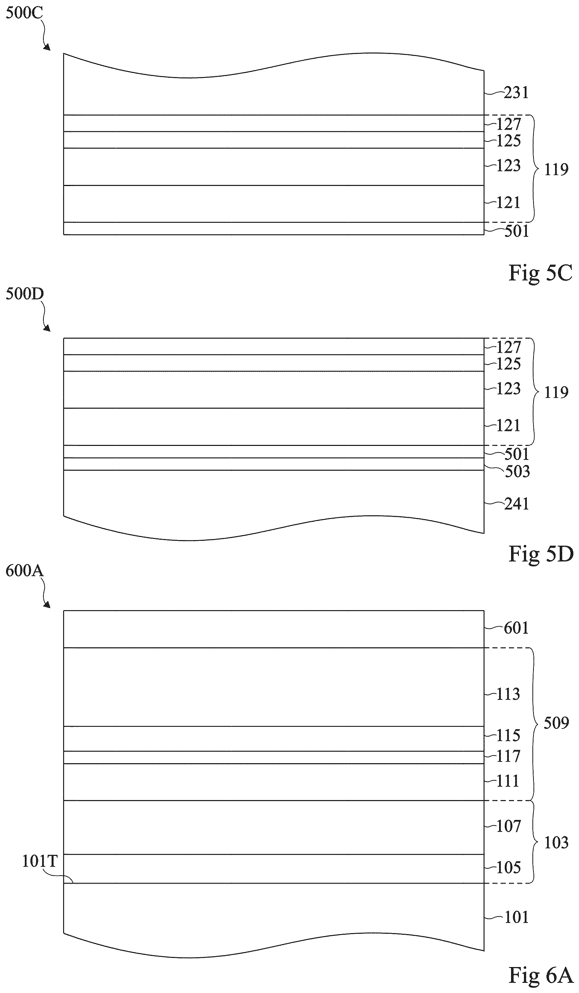

La figure 5A, la figure 5B, la figure 5C et la figure 5D sont des vues de côté et en coupe, schématiques et partielles, de structures obtenues à l'issue d'étapes successives d'un procédé de réalisation d'un dispositif électronique selon un mode de réalisation.

La figure 5A est une vue de côté et en coupe, schématique et partielle, d'une structure 500A obtenue à l'issue d'une étape d'un procédé de fabrication d'un dispositif électronique selon un mode de réalisation.

La structure 500A de la figure 5A comprend des éléments en commun avec la structure 100 précédemment décrite en relation avec la figure 1. Ces éléments communs ne seront pas détaillés à nouveau ci-après. La structure 500A diffère de la structure 100 en ce que la structure 500A comprend, à la place de l'empilement d'électropolissage 109, un empilement d'électropolissage 509 situé du côté de la face supérieure 101T du substrat de support 101. Dans l'exemple représenté, l'empilement d'électropolissage 509 revêt l'empilement 103 de couches tampon.

Dans l'exemple illustré en figure 5A, l'empilement d'électropolissage 509 comprend :
- la couche 111 de transition située sur et en contact avec la face supérieure de la couche tampon 107 ;
- la couche 117 sacrificielle située sur et en contact avec la face supérieure de la couche 111 ;
- la couche 115 de protection de la couche 113 située sur et en contact avec la face supérieure de la couche 117 ; et
- la couche 113 de transport de charges située sur et en contact avec la face supérieure de la couche 115.

Par ailleurs, la structure 500A comprend l'empilement actif 119 situé sur l'empilement d'électropolissage 509. Dans cet exemple, l'empilement 509 est interposé entre l'empilement 103 de couches tampon et l'empilement 119.

La figure 5B illustre une structure 500B obtenue, à partir de la structure 500A, à l'issue d'une étape ultérieure de formation des vias 323 de manière analogue ou identique à ce qui a été précédemment décrit en relation avec la figure 3A. Dans l'exemple illustré, trois vias 323 s'étendent verticalement depuis la face inférieure du substrat de support 101, à travers le substrat de support 101 et les couches 105 et 107 de l'empilement tampon 103, jusque dans l'épaisseur de la couche sacrificielle 117.

La figure 5C illustre une structure 500C obtenue, à partir de la structure 500B, à l'issue d'une étape ultérieure de retrait du substrat de support 101 par électropolissage de la couche sacrificielle 117, par exemple de manière analogue à ce qui a été décrit précédemment en relation avec la figure 3B. Au préalable, la poignée 231 est par exemple fixée sur la structure 500B du côté de la face supérieure de la couche 127.

Une fois l'électropolissage de la couche sacrificielle 117 réalisé, les couches 115 et 113 de l'empilement d'électropolissage 509 sont par exemple retirées par gravure, par exemple une gravure sèche ou humide. À titre de variante, les couches 115 et 113 sont retirées par l'application d'un potentiel plus élevé permettant de graver la couche 115, peu dopée, puis la couche 113, par exemple conformément à l'abaque de la figure 4.

Une couche 501 de collage est par exemple ensuite déposée sous la couche 121. Dans l'exemple représenté, la couche 501 est située sous et en contact avec une face inférieure de la couche 121, c'est-à-dire une face de la couche 121 opposée à la poignée 231.

La couche 501 est par exemple formée par un procédé de dépôt de couches minces atomiques, par exemple par ALD (de l'anglais « Atomic Layer Deposition » - dépôt de couches atomiques). La couche 501 est par exemple isolante, par exemple dans un cas où la structure 500C est utilisée pour la réalisation ultérieure d'un transistor HEMT dit « horizontal ». Dans ce cas, la couche est par exemple en un nitrure métallique isolant, par exemple l'AlN.

À titre de variante, la couche 501 est conductrice, par exemple dans un cas où un transistor HEMT dit « vertical » est ultérieurement réalisé à partir de la structure 500C. Dans cette variante, la couche 501 est par exemple en un métal, par exemple le tungstène ou le titane, ou en un nitrure métallique conducteur, par exemple le TiN.

À titre d'exemple, la couche 501 présente une épaisseur inférieure à 10 nm.

La figure 5D illustre une structure 500D obtenue, à partir de la structure 500C, à l'issue d'une étape ultérieure de report de la structure 500C sur le substrat de report 241 et de retrait de la poignée 231.

Dans l'exemple représenté, le substrat de report 241 est préalablement revêtu d'une couche 503, par exemple une couche de collage en le même matériau que la couche 501, par exemple l'AlN.

À titre d'exemple, la fixation de la structure 500C sur le substrat de report 241 est obtenue par collage direct, par exemple par collage moléculaire, entre les deux surfaces des couches 501 et 503 mises en contact.

Bien que cela n'ait pas été illustré, des étapes ultérieures de fabrication d'un composant électronique de puissance, comprenant par exemple au moins un transistor HEMT horizontal ou vertical, sont par exemple mises en œuvre à partir de la structure 500D. Ces étapes comprennent par exemple, dans le cas d'un transistor HEMT horizontal, la formation d'une structure identique ou analogue à celle du transistor HEMT précédemment décrite en relation avec la figure 2A.

Le procédé décrit ci-dessus en relation avec les figures 5A à 5D présente des avantages similaires à ceux des procédés précédemment décrits en relation avec les figures 2A à 2D et avec les figures 3A et 3B. Un autre avantage du procédé des figures 5A à 5Douche sacrificielle 117 préalablement à la réalisation du composant électronique de puissance. Cela permet d'éviter, ou de réduire, les risques d'endommagement du composant lors de la réalisation du dispositif électronique.

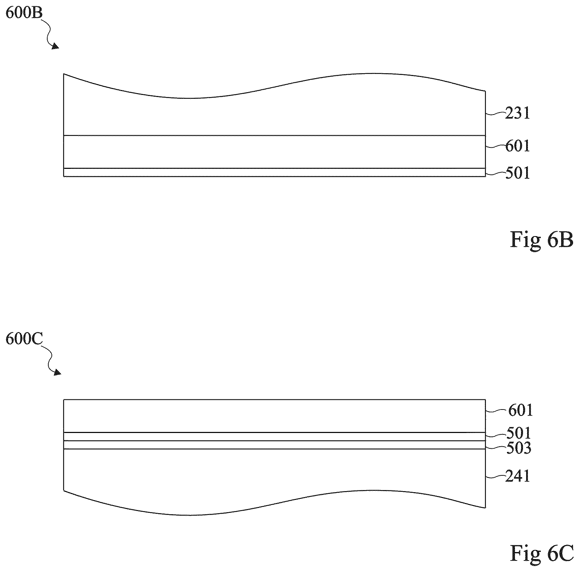

La figure 6A, la figure 6B et la figure 6C sont des vues de côté et en coupe, schématiques et partielles, de structures obtenues à l'issue d'étapes successives d'un procédé de réalisation d'un dispositif électronique selon un mode de réalisation.

La figure 6A est une vue de côté et en coupe, schématique et partielle, d'une structure 600A obtenue à l'issue d'une étape d'un procédé de fabrication d'un dispositif électronique selon un mode de réalisation.

La structure 600A de la figure 6A comprend des éléments en commun avec la structure 500 précédemment décrite en relation avec la figure 5A. Ces éléments communs ne seront pas détaillés à nouveau ci-après. La structure 600A diffère de la structure 500A en ce que la structure 600A comprend, à la place de l'empilement actif 119, au moins une couche à base de GaN. Dans l'exemple représenté, la structure 600A comprend, à la place de l'empilement actif 119, une unique couche 601 en GaN. Dans cet exemple, la couche 601 est située sur et en contact avec la face supérieure de la couche 113 de transport de charges. La structure 600A est par exemple dépourvue de couche active d'un composant électronique de puissance.

La figure 6B illustre une structure 600B obtenue, à partir de la structure 600A, à l'issue d'une étape ultérieure de retrait du substrat de support 101 par électropolissage de la couche sacrificielle 117, par exemple de manière analogue à ce qui a été décrit précédemment en relation avec la figure 3B. Au préalable, le ou les vias 323 sont par exemple formés depuis la face inférieure du substrat de support 101 et la poignée 231 est par exemple fixée sur la structure 600A du côté de la face supérieure de la couche 601.

Une fois l'électropolissage de la couche sacrificielle 117 réalisé, les couches 115 et 113 de l'empilement d'électropolissage 509 sont par exemple retirées par gravure, par exemple une gravure sèche ou humide.

La couche 501 de collage est par exemple ensuite déposée sous la couche 601. Dans l'exemple représenté, la couche 501 est située sous et en contact avec une face inférieure de la couche 601, c'est-à-dire une face de la couche 121 opposée à la poignée 231.

La figure 6C illustre une structure 600C obtenue, à partir de la structure 600B, à l'issue d'une étape ultérieure de report de la structure 600B sur le substrat de report 241 et de retrait de la poignée 231.

Dans l'exemple représenté, le substrat de report 241 est préalablement revêtu de la couche de collage 503. À titre d'exemple, la fixation de la structure 600B sur le substrat de report 241 est obtenue par collage direct, par exemple par collage moléculaire, entre les deux surfaces des couches 501 et 503 mises en contact.

Bien que cela n'ait pas été illustré, des étapes ultérieures de fabrication d'un composant électronique de puissance, comprenant par exemple au moins un transistor HEMT horizontal ou vertical, sont par exemple mises en œuvre à partir de la structure 600C. Ces étapes comprennent par exemple, dans le cas d'un transistor HEMT horizontal, la formation d'un empilement actif, par exemple identique ou analogue à l'empilement actif 119, et d'une structure identique ou analogue à celle du transistor HEMT précédemment décrite en relation avec la figure 2A.

Le procédé décrit ci-dessus en relation avec les figures 6A à 6C présente des avantages similaires à ceux des procédés précédemment décrits en relation avec les figures 2A à 2D et avec les figures 3A et 3B. Un autre avantage du procédé des figures 6A à 6C est qu'il permet d'obtenir un substrat en GaN - constitué, dans l'exemple représenté, par la couche 601 - présentant une qualité cristalline supérieure à celle des substrats existants. En outre, le fait de mettre en œuvre l'étape d'électropolissage de la couche sacrificielle 117 préalablement à la réalisation de l'empilement actif de composant électronique de puissance permet de réduire les risques d'endommagement de cet empilement lors de la réalisation du dispositif électronique.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la personne du métier est capable de transposer les modes de réalisation décrits en relation avec les figures 2A à 2D et avec les figures 3A et 3B au cas où la couche de transition 111 est présente.

Par ailleurs, bien que le cas de la formation d'un seul transistor HEMT ait été détaillé ci-dessus, les modes de réalisation décrits s'appliquent plus généralement à la formation, dans et sur l'empilement actif, d'un nombre quelconque de composants électroniques de puissance à base de GaN, par exemple un nombre quelconque de transistors HEMT.

Enfin, la mise en œuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés dans la présente description.

## Revendications

1. Procédé de réalisation d'un dispositif électronique, le procédé comprenant les étapes successives suivantes :
a) former, sur un substrat de support (101), un empilement d'électropolissage (109 ; 309 ; 509) comprenant :
- une première couche (117) semiconductrice sacrificielle ;
- une deuxième couche (113) semiconductrice de transport de charges ; et
- une troisième couche (115) semiconductrice de protection de la deuxième couche (113), la troisième couche (115) étant interposée entre les première (117) et deuxième (113) couches et présentant un niveau de dopage strictement inférieur à ceux des première (117) et deuxième (113) couches ;
b) former, du côté d'une face de l'empilement d'électropolissage (109 ; 309 ; 509) opposée au substrat de support (101), au moins une quatrième couche (121, 123, 125 ; 601) à base de nitrure de gallium ; et
c) retirer le substrat de support (101) par électropolissage de la première couche (117) en appliquant, entre une électrode en contact avec la deuxième (113) ou la troisième (115) couche et une contre-électrode disposée dans une solution électrolytique, un courant de polarisation traversant, dans cet ordre, les deuxième (113), troisième (115) et première (117) couches.

2. Procédé selon la revendication 1, comprenant en outre, postérieurement à l'étape c), une étape d) de report de ladite au moins une quatrième couche (121, 123, 125 ; 601) sur un substrat de report (241).

3. Procédé selon la revendication 1 ou 2, dans lequel ladite au moins une quatrième couche (121, 123, 125) fait partie d'un empilement actif (119) de composant électronique de puissance.

4. Procédé selon la revendication 3, comprenant en outre, entre les étapes b) et c), une étape de formation, dans et sur l'empilement actif (119), d'au moins un transistor HEMT.

5. Procédé selon la revendication 4, dans lequel la première couche (117) est située sur et en contact avec une face de la troisième couche (115) opposée au substrat de support (101).

6. Procédé selon la revendication 5, comprenant en outre, postérieurement à l'étape de formation dudit au moins un transistor HEMT et préalablement à l'étape c), une étape de formation d'un ou plusieurs vias (223) ou d'une ou plusieurs tranchées s'étendant depuis une face de l'empilement actif (119) opposée au substrat de support (101), à travers l'empilement actif (119) et à travers les deuxième (113) et troisième (115) couches, jusque dans l'épaisseur de la première couche (117).

7. Procédé selon la revendication 4, dans lequel la deuxième couche (113) est située sur et en contact avec une face de la troisième couche (115) opposée au substrat de support (101).

8. Procédé selon la revendication 7, comprenant en outre, postérieurement à l'étape de formation dudit au moins un transistor HEMT et préalablement à l'étape c), une étape de formation d'un ou plusieurs vias (323) s'étendant depuis une face du substrat de support (101) opposée à l'empilement d'électropolissage (309 ; 509), à travers le substrat de support (101), jusque dans l'épaisseur de la première couche (117).

9. Procédé selon la revendication 1 ou 2, dans lequel ladite au moins une quatrième couche (601) est une unique couche en nitrure de gallium.

10. Procédé selon la revendication 9, dans sa dépendance à la revendication 2, comprenant en outre, postérieurement à l'étape d), des étapes de formation d'un empilement actif (119) de composant électronique de puissance et de formation, dans et sur l'empilement actif (119), d'au moins un transistor HEMT.

11. Procédé selon l'une quelconque des revendications 1 à 10, dans lequel la première couche (117) présente un niveau de dopage au moins dix fois supérieur à celui de la troisième couche (115).

12. Procédé selon la revendication 11, dans lequel :
- les première (117) et deuxième (113) couches présentent chacune un niveau de dopage égal à environ 1.10¹⁹ at.cm⁻³ ; et
- la troisième couche (115) présente un niveau de dopage égal à environ 1.10¹⁶ at.cm⁻³.

13. Procédé selon l'une quelconque des revendications 1 à 12, comprenant en outre, entre les étapes b) et c), une étape de fixation d'une poignée (231) du côté d'une face de l'empilement d'électropolissage (109) opposée au substrat de support (101).

14. Procédé selon l'une quelconque des revendications 1 à 13, dans lequel l'empilement d'électropolissage (109) comprend en outre une cinquième couche (111) semiconductrice de transition interposée entre le substrat de support (101) et la première couche (117).

15. Procédé selon l'une quelconque des revendications 1 à 14, comprenant en outre, préalablement à l'étape a), une étape de formation, sur le substrat de support (101), d'un empilement tampon (103) comprenant au moins une couche (105, 107) d'adaptation de paramètre de maille et de coefficient d'expansion thermique.
